# EUROPÄISCHE PATENTSCHRIFT

(11) **EP 3 504 761 B1**
(45) Veröffentlichungstag und Bekanntmachung des Hinweises auf die Patenterteilung: **27.01.2021**
(21) Anmeldenummer: 17761005.2
(22) Anmeldetag: 15.08.2017
(51) Int. Cl.: H01R 13/514, H01R 13/66, H01R 24/64

(54) **STECKVERBINDER**
PLUG CONNECTOR
CONNECTEUR ENFICHABLE

(30) Priorität: 24.08.2016 DE 102016115665
(43) Veröffentlichungstag der Anmeldung: 03.07.2019
(73) Patentinhaber: Harting Electric GmbH & Co. KG, 32339 Espelkamp (DE)
(72) Erfinder: KROPIEWNICKI, Norbert, 33619 Bielefeld (DE)
(86) Internationale Anmeldenummer: PCT/DE2017/100688
(87) Internationale Veröffentlichungsnummer: WO 2018/036588

(56) Entgegenhaltungen:
- WO-A2-2015/149757
- GB-A- 2 453 064
- US-A- 5 998 738
- US-A1- 2005 239 343
- US-A1- 2009 147 482

## Beschreibung

Die Erfindung geht aus von einem Steckverbinder nach dem Oberbegriff des unabhängigen Anspruchs 1.

Derartige Steckverbinder werden benötigt, um Ströme und/oder Spannungen zu übertragen. Ferner ist es durch den Einsatz von Sensorik im Steckverbinder möglich, die, für die Übertragung benötigten, Kontakte zeitgleich zu überwachen.

Die DE 100 11 354 C1 zeigt ein elektrisches Gerät mit anreihbaren Modulen. Im Einsatz erwärmt sich das elektrische Gerät und muss gekühlt werden. Dies wird in der DE 100 11 354 C1 entweder durch einen Spalt zwischen Gehäuseboden und Montagefläche zum Erhalt der Luftzirkulation erreicht oder alternativ wird der Gehäuseboden sehr groß ausgeführt um möglichst viel Wärme abzugeben. Dadurch wird das elektrische Gerät sehr groß.

In Steckverbindern wird neuerdings Elektronik und/oder Sensorik direkt mit eingebaut. Dies ist aus der WO 2015/149757 A2 bekannt. Die WO 2015/149757 A2 zeigt ein Steckverbindersystem, bestehend aus mindestens einem Steckverbindermodul, welches in einem Halterahmen angeordnet ist. Das Steckverbindermodul weist einen Sensor auf, welcher über ein Bussystem mit einer Elektronik verbunden ist. Die Elektronik dient der Auswertung von Sensormessungen.

Aus der JP 2013-105714 A ist ein Kabel mit einem Stecker bekannt, wobei der Stecker zusätzlich noch einen Stromdetektor aufweist. Der Stromdetektor ist im inneren Teil des Steckers untergebracht und erfasst die Stromstärken, welche durch die Leiter des Kabels fließen.

Die DE 20 2007 018 306 U1 offenbart eine Messeinrichtung für modulare Steckverbinder. Die Aufgabe dieser Messeinrichtung ist die Überwachung und Erfassung von Messdaten. Bei den Messdaten handelt es sich um physikalische Größen, wie zum Beispiel Strom, Spannung, Druck oder Luftfeuchtigkeit. Dafür weist mindestens ein Kontakteinsatz einen Messsensor zur Erfassung der physikalischen Größen auf.

Auch die JP 2015-201401 A beschreibt, wie die JP 2013-105714 A, einen Hochvolt-Stecker mit einem darin aufgenommenen Stromsensor zur Ermittlung von magnetischen Feldern. Hier wird der Datenaustausch über reinkommende und abgehende Signale ermittelt, welche mittels eines Wechselrichters übertragen werden.

Ein Stecker mit einer Elektronikschaltung ist aus der DE 103 23 170 A1 bekannt. Dabei handelt es sich bei dem Stecker um einen Stecker, in dessen Gehäuse eine Elektronikschaltung integriert ist. Für diese Elektronikschaltung weist der Stecker eine eigene Kühlung auf. Bei dem Stecker handelt es sich insbesondere um einen Stecker für Fahrzeugelektronik

Die US 2009/147482 A1 offenbart ein Verfahren zur Herstellung einer elektrischen Steuervorrichtung.

Die GB 2 453 064 A zeigt ein Leiterkartenmodul, bestehend aus einer flexiblen Leiterkarte und darauf angeordneten Funktionseinheiten. Die Leiterkarte ist um ein Substrat gefaltet. Das ganze System wird mithilfe eines metallischen Bügels zusammengehalten.

Die US 5,998,738 A zeigt ein elektronisches Steuermodul welches zur Erhöhung seiner Robustheit mit einer ersten und einer zweiten Klebeschicht versehen ist.

Die US 2005/0239343 A1 offenbart eine elektronische Steuervorrichtung, welche ein Schaltungssubstrat umfasst, das aus vier starren Abschnitten und dazwischenliegenden flexiblen Abschnitten besteht, die seriell miteinander verbunden sind. Dieses Schaltungssubstrat ist in einem Gehäuse so untergebracht, dass die jeweiligen flexiblen Abschnitte um 180 ° gefaltet sind, um die jeweiligen starren Abschnitte parallel zueinander anzuordnen. Diese elektronische Steuervorrichtung wird in einem Automobil eingesetzt.

Als Möglichkeiten zum Kühlen von Gegenständen sind im Stand der Technik Lüfter und Kühlkörper bekannt. Diese kommen beispielsweise in Computern und Maschinenschaltschränken zum Einsatz. Sie kühlen durch den Austausch von warmer gegen kalte Luft, also genauer gesagt durch die Zirkulation von Luft.

Nachteilig bei den bekannten Lösungen ist jedoch, dass eine Wärmeabfuhr durch den Austausch von warmer und kalter Luft in einem geschlossenen System nicht möglich ist, da in einem geschlossenen System die Luft nicht zirkulieren kann. Ohne ausreichende Kühlung erreichen jedoch Systeme mit einer hohen Verlustleistung in einem geschlossenen System schnell eine Grenztemperatur, welche nicht überschritten werden sollte. Durch das Überschreiten der Grenztemperatur wird nicht nur die Lebenszeit der Elektronik verkürzt, im schlimmsten Fall wird diese komplett zerstört. Dies wiederum hätte den Austausch der Elektronik oder sogar des gesamten Gerätes/ Steckverbinders zur Folge.

### Aufgabenstellung

Die Aufgabe der Erfindung besteht darin, einen Steckverbinder mit einem Kühlelement vorzuschlagen, der kompakt gebaut werden kann und dennoch effektiv arbeitet.

Die Aufgabe wird durch die kennzeichnenden Merkmale des unabhängigen Anspruchs 1 gelöst.

Vorteilhafte Ausgestaltungen der Erfindung sind in den Unteransprüchen angegeben.

Bei der vorliegenden Erfindung handelt es sich um einen Steckverbinder. Der Steckverbinder hat eine Anschlussseite zum Anschließen zumindest eines elektrischen oder optischen oder pneumatischen Leiters. Bevorzugt wird jedoch ein elektrischer Leiter angeschlossen.

Der Anschlussseite gegenüberliegend weist der Steckverbinder eine Steckseite auf. Die Steckseite dient zur Kontaktierung des Steckverbinders mit einem Gegensteckverbinder.

Der Steckverbinder weist ein Gehäuse, einen Rahmen und mindestens einen Kontakteinsatz auf. Das Gehäuse und der Rahmen sind aus Metall oder aus einem anderen stabilen, leitfähigen Material, wie zum Beispiel einem Kunststoff mit einer metallischen Legierung, gebildet.

Der Rahmen ist vorzugsweise mehrteilig ausgeführt. Bevorzugterweise besteht der Rahmen aus mindestens zwei Hälften, wobei mindestens zwei Hälften gelenkig miteinander verbunden sind. Alternativ ist der Rahmen einteilig.

Der Rahmen ist im Gehäuse aufnehmbar. Ferner ist dieser mit dem Gehäuse verbindbar. Die Verbindung wird mittels Schrauben, Stiften, Bolzen oder ähnlichem erzeugt. Somit sind der Rahmen und das Gehäuse mechanisch verbunden, wobei die Verbindung zerstörungsfrei lösbar ist.

In den Rahmen ist mindestens ein Kontakteinsatz einsetzbar. Dieser mindestens eine Kontakteinsatz wird im Rahmen, insbesondere durch Rastnasen, fixiert. Weist der mindestens eine Kontakteinsatz Rastnasen auf, so weist der Rahmen entsprechende Ausnehmungen auf, in welche die Rastnasen eingreifen können. Der Rahmen kann einen oder mehrere Kontakteinsätze aufnehmen je nach Ausführung des Kontakteinsatzes.

Bei dem Kontakteinsatz handelt es sich um einen festpoligen Kontakteinsatz oder um einen modularen Kontakteinsatz. Wird ein festpoliger Kontakteinsatz in den Rahmen eingesetzt, so füllt dieser den Rahmen vollständig aus. Bei der Verwendung eines modularen Kontakteinsatzes können mehrere Kontakteinsätze in einen Rahmen eingesetzt werden, da sie bauartbedingt kleiner sind als festpolige Kontakteinsätze.

Vorzugsweise weist der Kontakteinsatz mindestens einen Kontakt, mindestens einen Sensor und mindestens eine Platine auf. Bei den Kontakten kann es sich um Kontakte für die Übertragung von Strömen, Daten oder Signalen handeln. Bevorzugt ist die Übertragung von Strömen. Die Anzahl der Kontakte ist beliebig.

Entsprechend der Anzahl an Kontakten sind im Kontakteinsatz Sensoren angeordnet. Dabei ist jeder Sensor einem Kontakt zugeordnet. Bei den Sensoren handelt es sich um Messsensoren, insbesondere um Sensoren zur Messung von Strom und Spannung an den Kontakten. Sind mehrere Kontakte in dem Kontakteinsatz verbaut, so kann statt einzelner Sensoren auch ein Sensorboard verwendet werden, auf dem die Sensoren angeordnet sind. Die Sensoren sind über Datenleitungen oder ähnliches mit der mindestens einen Platine verbunden.

Bei der mindestens einen Platine handelt es um eine handelsübliche Platine, insbesondere um eine Starr-Flex-Platine, da sich diese in den flexiblen Bereichen biegen lassen. Durch die Flexibilität kann die Platine platzsparend in den Kontakteinsatz eingesetzt werden. Bevorzugterweise ist die Platine u-förmig gebogen, wobei die zwei parallelen Schenkel länger ausgeführt sind als der einzelne Schenkel, welcher die beiden parallelen Schenkel verbindet.

Auf den beiden parallelen Schenkeln sind elektrische und/oder elektronische Bauteile montiert. Teilweise weisen diese Bauteile eine hohe Verlustleistung auf. Die Verlustleistung sorgt dafür, dass die entsprechenden Bauteile sehr warm werden. Die Bauteile bilden eine Auswertelektronik, insbesondere ein sogenanntes Embedded System.

Diese Auswertelektronik ist auf der Platine montiert. Die Auswertelektronik empfängt die Daten der Sensoren und verarbeitet diese. Ferner ist die Auswertelektronik in der Lage die Daten weiter zu versenden. Dies geschieht über eine Schnittstelle, welche zum Datentransfer geeignet ist. Die Platine ist mittels einer Lötverbindung oder einer Steckverbindung mit der Schnittstelle verbunden.

Die Schnittstelle ist auf der Steckseite des Steckverbinders angeordnet. Bei der Schnittstelle handelt es sich beispielsweise um eine RJ45-Buchse oder einen RJ45-Stift, je nach Ausführung des Steckverbinders. Es kann auch jede andere Ausführung einer Schnittstelle gewählt werden, welche zum Datentransfer geeignet ist.

Erfindungsgemäß weist der Steckverbinder ein Kühlelement auf. Das Kühlelement dient der Abfuhr von Wärme. Wärme entsteht, wie oben beschrieben, auf der Platine durch die Auswertelektronik. Die entstehende Wärme kann jedoch nicht ausreichend durch die natürliche Konvektion abgeführt werden, da die Platine vom Gehäuse fast vollständig umschlossen ist. Die Auswertelektronik erwärmt sich folglich zu stark. Die Grenzwerttemperaturen der Bauteile werden ohne eine Wärmeabfuhr überschritten. Dies hätte eine Zerstörung der Auswertelektronik und damit des gesamten Steckverbinders zur Folge. Um diese Gefahr zu reduzieren, wird das erfindungsgemäße Kühlelement im Steckverbinder eingesetzt.

Das Kühlelement besteht aus einem wärmeleitfähigen Material, damit ein Wärmetransport weg von der Wärmequelle ermöglicht wird. Vorteilhafterweise besteht das Kühlelement dabei aus Metall und in einer besonders vorteilhaften Variante aus Kupfer. Die Verwendung eines metallischen Kühlelements ist auf Grund der guten Wärmeleitfähigkeit von Metallen bevorzugt. Kupfer weist dabei mit ca. 400 W/(m*K) die höchste Wärmeleitfähigkeit der Metalle auf und ist deshalb besonders bevorzugt einzusetzen.

Das Kühlelement ist u-förmig gebogen. Es weist zwei parallel verlaufende Schenkel auf. Diese sind mit einem Schenkel verbunden, welcher kürzer ist als die beiden parallelen Schenkel. Einer der beiden parallelen Schenkel hat Kontakt zum Rahmen. Durch den Kontakt zum Rahmen kann die entstehende Wärme von der Platine über das Kühlelement und weiter über den Rahmen an das Gehäuse abgeleitet werden. Idealerweise verrastet einer der beiden parallelen Schenkel des Kühlelements mit dem Rahmen und ist so fixiert.

In einer vorteilhaften Ausgestaltung sind die Platine und das Kühlelement senkrecht zueinander und bereichsweise ineinandergreifend angeordnet.

Dabei ragt ein paralleler Schenkel des Kühlelements senkrecht in den Bereich zwischen den beiden parallelen Schenkeln der Platine ohne diese zu berühren. Ferner ist die Fläche des parallelen Schenkels des Kühlelements parallel zu den beiden parallelen Flächen der parallelen Schenkel der Platine. Zusätzlich weist die Fläche des kürzeren Schenkels des Kühlelements in Richtung der Anschlussseite des Steckverbinders.

Um die Stabilität der Platine in ihrer u-Form zu erhöhen und zur Gewährleistung, dass der Schenkel des Kühlelements nicht in Kontakt mit der Platine kommt, ist die Verwendung eines Abstandhalters vorteilhaft. Dieser ist variabel einstellbar, beispielsweise mittels Raststufen, Nuten oder mittels einer schraubenähnlichen Struktur. Der Abstandhalter gewährleistet die Arretierung und korrekte Positionierung der Platine und des Kühlelements.

Idealerweise ist der Abstandhalter mit dem Schenkel des Kühlelements, welcher in den Bereich zwischen den parallelen Schenkeln der Platine ragt, fest verbunden und in den beiden parallelen Schenkeln der Platine schwimmend gelagert. Die schwimmende Lagerung wird durch eine Bohrung in der Platine erreicht. Die Bohrung ist dabei im Durchmesser größer als der Durchmesser des Abstandhalters. Durch die schwimmende Lagerung ist die Platine von Steck- und Ziehkräften weitestgehend entkoppelt.

Um die Stabilität zwischen dem Kühlelement und der Platine zu erhöhen, ist die Verwendung mindestens eines Lückenfüllers vorteilhaft. Dieser kann zusätzlich zum Abstandhalter eingesetzt werden. Der mindestens eine Lückenfüller füllt den Bereich zwischen den beiden parallelen Schenkeln der Platine und dem Schenkel des Kühlelements aus. Alternativ können anstelle eines Lückenfüllers auch mindestens zwei Lückenfüller verwendet werden. Bei mehr als einem Lückenfüller ist jeweils mindestens ein Lückenfüller zwischen einem der beiden parallelen Schenkel der Platine und dem Schenkel des Kühlelements angeordnet.

Der Lückenfüller ist aus wärmeleitfähigem Material. Bei dem Material ist die Verwendung eines wärmeleitfähigen Kunststoffes vorteilhaft, da dieser elastisch ist und damit auch stoßdämpfend. Idealerweise handelt es sich bei dem Material um Silikon oder alternativ um ein sogenanntes Wärmeleitpad. Silikon oder auch die Wärmeleitpads weisen für Kunststoffe die höchsten Werte in der Wärmeleitfähigkeit. Silikon besitzt eine Wärmeleitfähigkeit von ca. 0,5 W/(m*K) bis 5 W/(m*K).

Durch den Einsatz mindestens eines Lückenfüllers ist eine zusätzliche Wärmeabfuhr möglich. Diese kann die Wirkung des Kühlelements unterstützen. Ferner unterstützt der Lückenfüller die Funktion des Abstandhalters.

Die vorliegende Erfindung löst die Aufgabe eine Platine mit der darauf verbauten Elektronik im Steckverbinder vor dem Überschreiten der Grenztemperatur zu schützen, indem eine sichere Wärmeabfuhr von der Platine weg erfolgt. Zusätzlich ist die Position der Platine in dem Steckverbinder sicher und stabil gewährleistet, sowie das Kühlelement kompakt, platzsparend gebaut. Des Weiteren wird durch den Einsatz des Kühlelements die Lebensdauer der eingebauten Elektronik und damit des Steckverbinders erhöht.

### Ausführungsbeispiel

Ein Ausführungsbeispiel der Erfindung ist in den Zeichnungen dargestellt und wird im Folgenden näher erläutert. Es zeigen:
- Fig. 1: eine perspektivische Darstellung eines im Rahmen aufgenommenen Kontakteinsatzes
- Fig. 2: eine perspektivische Darstellung einer Platine mit Kühlelement und Schnittstelle
- Fig. 3: eine Schnittdarstellung

Die Figuren enthalten teilweise vereinfachte, schematische Darstellungen. Zum Teil werden für gleiche, aber gegebenenfalls nicht identische Elemente identische Bezugszeichen verwendet. Verschiedene Ansichten gleicher Elemente könnten unterschiedlich skaliert sein.

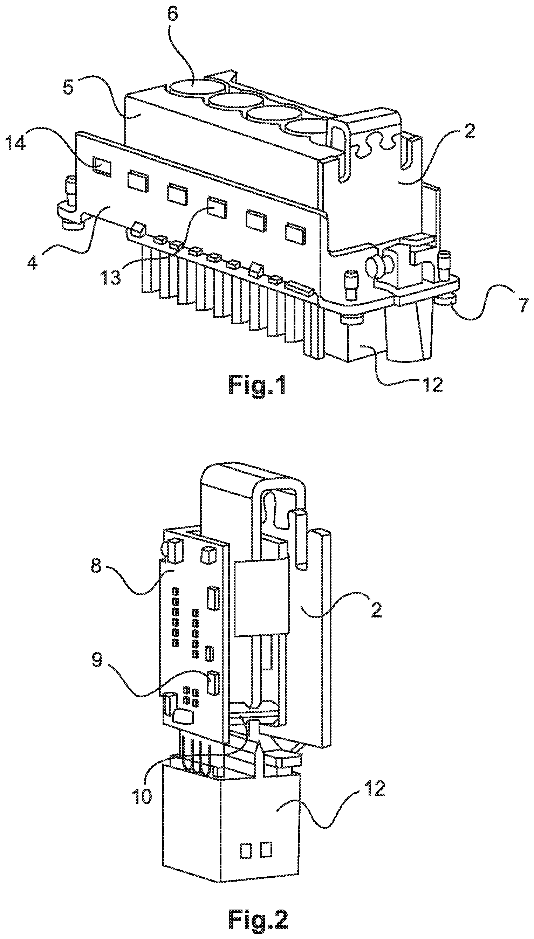

Die Figur 1 zeigt eine perspektivische Ansicht eines Rahmens 4 mit eingesetztem Kontakteinsatz 5 und einem erfindungsgemäßen Kühlelement 2. Bei dem Rahmen 4 handelt es sich um einen rechteckigen, zweiteiligen Rahmen. Bei dem Rahmen 4 sind die beiden Hälften miteinander über Gelenke verbunden.

An den vier Eckpunkten des zusammengebauten Rahmens 4 sind Mittel angeordnet, mit denen der Rahmen 4 in einem Gehäuse befestigt werden kann. Im vorliegenden Ausführungsbeispiel handelt es sich bei diesem Mittel um jeweils eine Schraube 7 je Ecke des Rahmens 4. Der Rahmen 4 weist an beiden Hälften jeweils mindestens eine Ausnehmung 14 auf. Die Ausnehmungen 14 der beiden Hälften liegen einander gegenüber und dienen der Aufnahme mindestens eines Kontakteinsatzes 5.

Um in den Ausnehmungen 14 des Rahmes 4 gehalten zu werden, weist der mindestens eine Kontakteinsatz 5 eine entsprechende Anzahl an Rastnasen 13 auf. Die Rastnasen 13 sind so geformt, dass sie in die Ausnehmungen 14 eingreifen und deren Form entsprechen. In diesem Ausführungsbeispiel weist der Rahmen 4 sechs Ausnehmungen 14 auf. Der Kontakteinsatz 5 weist fünf Rastnasen 13 auf, welche in den entsprechenden Ausnehmungen 14 verrastet sind.

In dem Kontakteinsatz 5 ist mindestens ein Kontakt 6 aufgenommen. Hier sind es beispielsweise vier Kontakte 6. Die Kontakte 6 weisen auf der Anschlussseite Öffnungen für eine Aufnahme eines elektrischen Leiters auf. Auf der Steckseite sind die Kontakte 6 so ausgeformt, dass sie mit einem Gegensteckverbinder kontaktiert werden können. Die Kontakte 6 weisen jeweils einen Messsensor, alternativ alle Kontakte 6 zusammen ein Sensorboard auf.

Ferner ist in dem Kontakteinsatz 5 eine Platine 8 mit einem erfindungsgemäßen Kühlelement 2 aufgenommen. Die Platine 8 ist vollständig im Kontakteinsatz 5 aufgenommen. Das Kühlelement 2 ist u-förmig gebogen. Einer der beiden längeren, parallelen Schenkel des Kühlelements ist im Bereich der Platine 8 angeordnet. Der andere parallele Schenkel des Kühlelements 2 ist mit dem Rahmen 4 verbunden. Der kürzere, die beiden parallelen Schenkel des Kühlelements 2 verbindende, Schenkel weist in Richtung der Anschlussseite des Steckverbinders. Auf der Steckseite, also dem Kühlelement 2 und der Platine 8 gegenüberliegend, ist die Schnittstelle 12 angeordnet. Die Verbindung zwischen der Platine 8 und der Schnittstelle 12 ist eine Lötverbindung. Bei der Schnittstelle 12 handelt es sich exemplarisch um eine RJ45-Buchse.

Die Figur 2 zeigt eine perspektivische Ansicht der Platine 8 mit dem Kühlelement 2 und der Verbindung zur Schnittstelle 12. Bei der Figur 2 handelt es sich um eine detaillierte Ansicht der in Figur 1 verbauten Platine 8 und dem Kühlelement 2. Die Platine 8 ist wie schon bei Figur 1 beschrieben mittels einer Lötverbindung mit der Schnittstelle 12 verbunden. In diesem Ausführungsbeispiel handelt es sich um vier Verbindungspunkte an denen sich Lötstellen befinden.

Die Platine 8 ist u-förmig gebogen. Sie weist zwei parallele Schenkel auf. Diese sind durch einen kürzeren, in etwa rechtwinklig zu den beiden parallelen Schenkeln angeordneten, Schenkel verbunden. Dieser kürzere Schenkel der Platine 8 ragt in Richtung der Ausnehmungen 14 des Rahmens 4 oder in Richtung der Rastnasen 13 des Kontakteinsatzes 5.

Die beiden parallelen Schenkel der Platine 8 sind mit mindestens einem elektronischen/ elektrischen Bauteil bestückt. Idealerweise bildet dieses mindestens eine Bauteil eine Auswertelektronik 9. Die Auswertelektronik 9 ist so aufgebaut, dass sie Daten von den Sensoren an den Kontakten 6 empfangen, verarbeiten und über die Schnittstelle 12 versenden kann.

Das Kühlelement 2 ragt mit einem der beiden parallelen Schenkel in den Bereich zwischen die beiden parallelen Schenkel der Platine 8 ohne diese zu berühren. Der kürzere Schenkel des Kühlelements 2 weist in Richtung der Anschlussseite.

Der andere der beiden parallelen Schenkel des Kühlelements 2 ist mit dem Rahmen 4 verbunden und hat ebenfalls keinen Kontakt zur Platine 8. Um die Stabilität der Verbindung zwischen dem Rahmen 4 und dem Kühlelement 2 zu erhöhen, weist der Rahmen 4 oder alternativ die Schnittstelle 12 ein Mittel zur Verrastung des Kühlelements 2 auf.

An dem Schenkel des Kühlelements 2, welcher in dem Bereich zwischen den beiden parallelen Schenkel der Platine 8 angeordnet ist, ist eine Aufnahme vorgesehen. Auf entsprechend derselben Höhe auf den beiden parallelen Schenkeln der Platine sind ebenfalls Bohrungen angeformt.

In der Aufnahme an dem Kühlelement 2 ist ein Abstandhalter 10 aufgenommen. Dieser ist in der Aufnahme am Kühlelement 2 relativ fest fixiert. Der Abstandhalter 10 ist in den Aufnahmen an den Schenkeln der Platine 8 aufgenommen. Jedoch sind die Aufnahmen an der Platine 8 größer im Durchmesser als der Durchmesser des Abstandshalters 10. Dies gewährleistet die Entkopplung der Platine 8 von Steck- und Ziehkräften. Der Abstandhalter dient zusätzlich der Arretierung der Platine 8 und des Kühlelements 2.

In dem vorliegenden Ausführungsbeispiel weist der Abstandhalter 10 Nuten auf, in denen die Platine 8 und/oder das Kühlelement 2 gehalten werden. Alternativ kann der Abstandhalter 10 auch schraubenähnlich oder mit Raststufen ausgeformt sein. Idealerweise ist der Abstandhalter 10 zylinderförmig, alternativ quaderförmig.

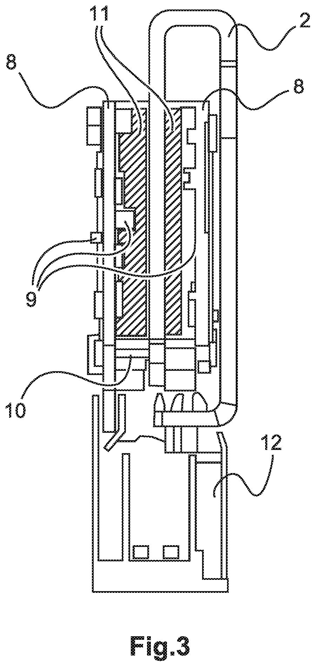

Die Figur 3 zeigt eine Schnittdarstellung einer besonderen Ausführungsform. Der Schnitt erfolgt durch die Platine 8 mit der Auswertelektronik 9, das Kühlelement 2, den Abstandhalter 10 und die Schnittstelle 12. In diesem Ausführungsbeispiel wird deutlich, dass eine Verrastung des Kühlelements 2 vorteilhaft ist. Idealerweise ist die Verrastung, beispielsweise in Form von Rastnasen 13, hierfür im Bereich der Schnittstelle 12 angeordnet.

Der eine parallele Schenkel des Kühlelements 2, welcher sich nicht im Bereich zwischen den parallelen Schenkeln der Platine 8 befindet, ist länger ausgeführt als der andere. Dieses längere Stück ist im rechten Winkel in Richtung der Platine 8 gebogen. Es weist Ausnehmungen 14 auf, in welche Rastnasen 13 oder andere Rastausführungen einrasten können. Dadurch werden vorteilhafterweise die Steck- und Ziehkräfte, welche auf die Platine 8 wirken würden, weiter reduziert.

In dieser bevorzugten Ausführungsform ist zwischen den parallelen Schenkeln der Platine 8 und dem Kühlelement 2 jeweils ein Lückenfüller 11 angeordnet.

Bei dem Lückenfüller 11 handelt es sich um ein Wärmeleitpad aus Silikon. Dies erhöht die Wärmeabfuhr, sowie die Stabilität zwischen der Platine 8 und dem Kühlelement 2. Der Lückenfüller 11 kann individuell angeformt werden oder weist eine vorgefertigte Form auf. Durch den Einsatz des Kühlelements 2 in Kombination mit dem Lückenfüller 11 ist eine besonders gute Wärmeabfuhr in Richtung des Rahmens 4 möglich, wodurch ein Überhitzen der Auswertelektronik 9 verhindert wird.

### Steckverbinder

### Bezugszeichenliste

- 2: Kühlelement
- 4: Rahmen
- 5: Kontakteinsatz
- 6: Kontakt
- 7: Schraube
- 8: Platine
- 9: Auswertelektronik
- 10: Abstandhalter
- 11: Lückenfüller
- 12: Schnittstelle
- 13: Rastnase
- 14: Ausnehmung

## Patentansprüche

1. Steckverbinder mit einer Steckseite und einer Anschlussseite, aufweisend ein Gehäuse, einen Rahmen (4) und mindestens einen Kontakteinsatz (5), wobei das Gehäuse und der Rahmen aus Metall oder aus einem anderen leitfähigen Material gebildet sind, wobei der Rahmen im Gehäuse aufnehmbar ist und wobei der mindestens eine Kontakteinsatz in den Rahmen einsetzbar ist, wobei der mindestens eine Kontakteinsatz (5) mindestens einen Kontakt (6), mindestens einen, dem jeweiligen Kontakt (6) zugeordneten, Sensor sowie eine Platine (8) aufweist, wobei die Platine (8) im Steckbereich des Steckverbinders eine Schnittstelle (12) aufweist, wobei die Platine (8) eine Auswertelektronik (9) aufweist, und wobei die Auswertelektronik (9) Daten von dem mindestens einen Sensor empfängt, auswertet und über die Schnittstelle (12) versendet, wobei der Steckverbinder ein Kühlelement (2) aufweist, wobei das Kühlelement (2) u-förmig gebogen ist und zwei parallele Schenkel aufweist wobei einer der beiden parallelen Schenkel Kontakt zum Rahmen hat, wobei die Platine (8) u-förmig gebogen im Kontakteinsatz (5) angeordnet ist und zwei parallele Schenkel aufweist, und wobei das Kühlelement (2) mit einem der beiden parallelen Schenkel des Kühlelementes (2) in den Bereich zwischen den beiden parallelen Schenkeln der Platine (8) ragt ohne diese zu berühren.

2. Steckverbinder nach Anspruch 1 **dadurch gekennzeichnet, dass** das Kühlelement (2) aus einem wärmeleitfähigen Material besteht.

3. Steckverbinder nach Anspruch 1 oder 2
**dadurch gekennzeichnet, dass**
das Kühlelement (2) aus Metall, insbesondere aus Kupfer, besteht.

4. Steckverbinder nach einem der vorstehenden Ansprüche **dadurch gekennzeichnet, dass**
ein Schenkel des Kühlelements (2) Kontakt zum Gehäuse hat.

5. Steckverbinder nach einem der vorstehenden Ansprüche **dadurch gekennzeichnet, dass**
die Platine (8) starre und flexible Bereiche aufweist, wobei die Platine (8) bevorzugt eine Starr-Flex-Platine ist.

6. Steckverbinder nach einem der vorstehenden Ansprüche **dadurch gekennzeichnet, dass**
die Platine (8) und das Kühlelement (2) senkrecht zueinander und bereichsweise ineinandergreifend angeordnet sind.

7. Steckverbinder nach einem der vorstehenden Ansprüche **dadurch gekennzeichnet, dass**
ein Abstandhalter (10) die Platine (8) und das Kühlelement (2) voneinander beabstandet positioniert.

8. Steckverbinder nach Anspruch 7
**dadurch gekennzeichnet, dass**
der Abstandhalter (10) variabel einstellbar ist.

9. Steckverbinder nach einem der vorstehenden Ansprüche
**dadurch gekennzeichnet, dass**
mindestens ein Lückenfüller (11) zwischen der Platine (8) und dem Kühlelement (2) angeordnet ist.

10. Steckverbinder nach Anspruch 9
**dadurch gekennzeichnet, dass**
der Lückenfüller (11) aus einem wärmeleitenden Material, bevorzugt Silikon, besteht.

11. Steckverbinder nach einem der vorstehenden Ansprüche **dadurch gekennzeichnet, dass**
die Auswertelektronik (9) ein Embedded System ist.

12. Steckverbinder nach einem der vorstehenden Ansprüche **dadurch gekennzeichnet, dass**
die Schnittstelle (12) ein RJ45-Anschluss oder eine RJ45-Buchse ist.

13. Steckverbinder nach Anspruch 12
**dadurch gekennzeichnet, dass**
die Platine (8) eine Lötverbindung aufweist, wobei die Lötverbindung die Schnittstelle (12) und die Platine (8) verbindet.

## Claims

1. Plug-in connector having a plug-in side and a connection side, comprising a housing, a frame (4) and at least one contact insert (5), wherein the housing and the frame are embodied from a metal or from another conductive material, wherein the frame may be accommodated in the housing and wherein the at least one contact insert may be inserted into the frame, wherein the at least one contact insert (5) comprises at least one contact (6), at least one sensor that is allocated to the respective contact (6), and also a circuit board (8), wherein the circuit board (8) comprises an interface (12) in the plug-in region of the plug-in connector, wherein the circuit board (8) comprises an electronic evaluating system (9), and wherein the electronic evaluating system (9) receives and evaluates data from the at least one sensor and transmits said data via the interface (12), wherein the plug connector comprises a cooling element (2), wherein the cooling element (2) is curved in a U-shaped manner and comprises two parallel limbs, wherein one of the two parallel limbs is in contact with the frame, wherein the circuit board (8) is arranged curved in a U-shaped manner in the contact insert (5) and comprises two parallel limbs, and wherein the cooling element (2) protrudes with one of the two parallel limbs of the cooling element (2) into the region between the two parallel limbs of the circuit board (8) without coming into contact with said circuit board.

2. Plug-in connector according to Claim 1, **characterized in that** the cooling element (2) is embodied from a thermally conductive material.

3. Plug-in connector according to Claim 1 or 2, **characterized in that** the cooling element (2) is embodied from metal, in particular from copper.

4. Plug-in connector according to any one of the preceding claims, **characterized in that** one limb of the cooling element (2) makes contact with the housing.

5. Plug-in connector according to any one of the preceding claims, **characterized in that** the circuit board (8) comprises rigid and flexible regions, wherein the circuit board (8) is preferably a rigid-flexible circuit board.

6. Plug-in connector according to any one of the preceding claims, **characterized in that** the circuit board (8) and the cooling element (2) are arranged in a manner perpendicular with respect to one another and engaging with one another in regions.

7. Plug-in connector according to any one of the preceding claims, **characterized in that** a spacer (10), the circuit board (8) and the cooling element (2) are positioned spaced apart from one another.

8. Plug-in connector according to Claim 7, **characterized in that** the spacer (10) may be adjusted in a variable manner.

9. Plug-in connector according to any one of the preceding claims, **characterized in that** at least one gap filler (11) is arranged between the circuit board (8) and the cooling element (2).

10. Plug-in connector according to Claim 9, **characterized in that** the gap filler (11) is embodied from a thermally conductive material, preferably silicone.

11. Plug-in connector according to any one of the preceding claims, **characterized in that** the electronic evaluating system (9) is an embedded system.

12. Plug-in connector according to any one of the preceding claims, **characterized in that** the interface (12) is an RJ45 connection or an RJ45 socket.

13. Plug-in connector according to Claim 12, **characterized in that** the circuit board (8) comprises a solder connection, wherein the solder connection connects the interface (12) and the circuit board (8).

## Revendications

1. Connecteur électrique comportant un côté enfichage et un côté connexion, présentant un boîtier, un cadre (4) et au moins un insert de contact (5), dans lequel le boîtier et le cadre sont constitués de métal ou d'un autre matériau conducteur, dans lequel le cadre peut être logé dans le boîtier et dans lequel au moins un insert de contact peut être inséré dans le cadre,
dans lequel ledit au moins un insert de contact (5) présente au moins un contact (6), au moins un capteur associé au contact (6) respectif ainsi qu'une carte (8), dans lequel la carte (8) présente une interface (12) dans la zone d'enfichage du connecteur électrique,
dans lequel la carte (8) présente une électronique d'évaluation (9), et
dans lequel l'électronique d'évaluation (9) reçoit des données en provenance dudit au moins un capteur, les évalue et les transmet par l'intermédiaire de l'interface (12),
dans lequel le connecteur électrique présente un élément de refroidissement (2),
dans lequel l'élément de refroidissement (2) est recourbé en forme de U et possède deux branches parallèles, dans lequel l'une des deux branches parallèles est en contact avec le cadre,
dans lequel la carte (8) est disposée dans l'insert de contact (5) recourbé en forme de U et présente deux branches parallèles, et
dans lequel l'élément de refroidissement (2) fait saillie avec l'une des deux branches parallèles de l'élément de refroidissement (2) dans la zone située entre les deux branches parallèles de la carte (8) sans toucher cette dernière.

2. Connecteur électrique selon la revendication 1, **caractérisé en ce que** l'élément de refroidissement (2) est constitué d'un matériau thermiquement conducteur.

3. Connecteur électrique selon la revendication 1 ou 2, **caractérisé en ce que** l'élément de refroidissement (2) est constitué de métal, en particulier de cuivre.

4. Connecteur électrique selon l'une des revendications précédentes,
**caractérisé en ce qu'**une branche de l'élément de refroidissement (2) est en contact avec le boîtier.

5. Connecteur électrique selon l'une des revendications précédentes,
**caractérisé en ce que** la carte (8) comporte des zones rigides et flexibles, dans lequel la carte (8) est de préférence une carte rigide-flexible.

6. Connecteur électrique selon l'une des revendications précédentes,
**caractérisé en ce que** la carte (8) et l'élément de refroidissement (2) sont disposés perpendiculairement l'un à l'autre et engagés l'un dans l'autre par zones.

7. Connecteur électrique selon l'une des revendications précédentes,
**caractérisé en ce qu'**une pièce d'écartement (10) positionne la carte (8) et l'élément de refroidissement (2) de manière espacée l'un de l'autre.

8. Connecteur électrique selon la revendication 7, **caractérisé en ce que** la pièce d'écartement (10) est réglable de manière variable.

9. Connecteur électrique selon l'une des revendications précédentes,
**caractérisé en ce qu'**au moins un élément de remplissage d'interstice (11) est disposé entre la carte (8) et l'élément de refroidissement (2).

10. Connecteur électrique selon la revendication 9, **caractérisé en ce que** l'élément de remplissage d'interstice (11) est constitué d'un matériau thermiquement conducteur, de préférence de silicone.

11. Connecteur électrique selon l'une des revendications précédentes,
**caractérisé en ce que** l'électronique d'évaluation (9) est un système embarqué.

12. Connecteur électrique selon l'une des revendications précédentes,
**caractérisé en ce que** l'interface (12) est une fiche RJ45 ou une douille RJ45.

13. Connecteur électrique selon la revendication 12, **caractérisé en ce que** la carte (8) est munie d'une connexion soudée, dans lequel la connexion soudée relie l'interface (12) et la carte (8).
